**Europäisches Patentamt**

**European Patent Office**

**Office européen des brevets**

(19)

(11) Veröffentlichungsnummer : **0 573 409 B1**

(12) **EUROPÄISCHE PATENTSCHRIFT**

(45) Veröffentlichungstag der Patentschrift :
31.05.95 Patentblatt 95/22

(51) Int. Cl.⁶ : **H03D 3/00,** H03D 1/00, H03M 1/06, H03M 1/20, H03M 3/02

(21) Anmeldenummer : 91900772.4

(22) Anmeldetag : 19.12.90

(86) Internationale Anmeldenummer :
PCT/EP90/02253

(87) Internationale Veröffentlichungsnummer :
WO 91/10283 11.07.91 Gazette 91/15

(54) **EIN INTERPOLATIVER A/D UMSETZER FÜR BANDPASSSIGNALE.**

(30) Priorität : 27.12.89 DE 3943072

(43) Veröffentlichungstag der Anmeldung :
15.12.93 Patentblatt 93/50

(45) Bekanntmachung des Hinweises auf die
Patenterteilung :
31.05.95 Patentblatt 95/22

(84) Benannte Vertragsstaaten :
DE ES FR GB

(56) Entgegenhaltungen :
EP-A- 0 080 014
GB-A- 2 171 569
US-A- 4 737 728
US-A- 4 750 214

(56) Entgegenhaltungen :
US-A- 4 888 557
ELECTRONICS LETTERS, Bd. 25, Nr. 23, 9.November 1989, R. SCHREIER et al.: "Bandpass sigma-delta modulation", pages 1560-1561

(73) Patentinhaber : **AEG MOBILE COMMUNICATION GmbH
Wilhelm-Runge-Strasse 11
D-89081 Ulm (DE)**

(72) Erfinder : **DRESSLER, Hans-Joachim
Wielandstrasse 15
D-7909 Dornstadt (DE)**

(74) Vertreter : **Körner, Ekkehard, Dipl.-Ing. et al
Patentanwalt
Maximilianstrasse 58
D-80538 München (DE)**

## Beschreibung

Die Erfindung bezieht sich auf einen interpolativen Analog/Digital (A/D)-Umsetzer nach dem Oberbegriff des Patentanspruches 1, insbesondere zur Umsetzung von analogen Bandpaßsignalen im Trägerfrequenz- oder Zwischenfrequenzbereich in Funkempfängern.

Es ist bekannt, daß durch die Digitalisierung und digitale Weiterverarbeitung von Signalen der Schaltungsaufwand verringert werden kann und insbesondere die Nachteile durch nichtideale Bauelementeigenschaften (Rauschen, Alterung, Temperaturdrift, DC-Offset usw.) vermieden werden.

Beispielsweise ist aus NTZ-Archiv, Band 5, Heft 12/1983, S.353 ff. ein Funkempfänger bekannt, bei welchem das bandbegrenzte Eingangssignal eines Funkempfängers abgetastet und in eine Folge von Digitalwerten umgesetzt wird. In der US-A 4 750 214 ist ein ähnlicher Funkempfänger beschrieben, bei welchem das Eingangssignal vor der Digitalisierung noch in eine Zwischenfrequenzlage umgesetzt wird. In beiden Fällen werden die digitalisierten Werte in einer digitalen Quadraturumsetzung und digitalen Demodulation weiterverarbeitet. Bei einem in der US-A 4 888 557 beschriebenen Empfänger ist für die Digitalisierung und digitale Weiterverarbeitung von analogen Bandpaßsignalen darüberhinaus eine vorteilhafte Bemessung für die Abtastfrequenz des A/D-Umsetzers bezüglich der Mittenfrequenz der Bandpaßsignale sowie daraus abgeleitet eine digitale Mischfrequenz und ein Sortiersignal für die Inphase- und Quadraturkomponenten angegeben.

Der Nachteil dieser bekannten Lösungen liegt darin, daß der Analog/Digital-Umsetzer das Bandpaßsignal bereits an der A/D-Schnittstelle mit der vollen Amplitudenauflösung umsetzt und somit sehr aufwendig mit vielen Präzisionselementen ausgestaltet sein muß. Eine solche Lösung weist zum einen hohe Kosten auf, zum anderen muß bei der A/D-Umsetzung der Abtastzeitpunkt umso genauer eingehalten werden, je höher die zu verarbeitenden Signalanteile sind und je feiner das Eingangssignal aufgelöst werden soll. Da im Schaltverfahren dieser Bauelemente gewisse Streuungen nicht völlig beseitigt werden können, wird die mit herkömmlichen Verfahren erreichbare Amplitudenauflösung nach oben begrenzt.

Verfahren zur Analog-Digitalumsetzung von Signalen mit nur wenigen Quantisierungsstufen an der Analog-Digital-Schnittstelle aber dennoch hoher Auflösung sind interpolative Verfahren. Das interpolative Verfahren zur Analog-Digital-Umsetzung führt die Amplitudenquantisierung der Abtastwerte in zwei hintereinandergeschalteten Stufen durch. Dabei enthält die erste Stufe (Stufe 1) die eigentliche Analog-Digital-Schnittstelle, während die zweite Stufe (Stufe 2) rein digitale Funktionen aufweist. Die Amplitudenquantisierung der Abtastwerte erfolgt hier anders als bei nicht interpolativen Verfahren nicht mit feinquantisierenden Elementen an der Analog-Digital-Schnittstelle, sondern durch Überabtastung, spektrale Formung des Quantisierungsrauschens in der ersten Stufe und digitale Interpolation in der zweiten Stufe.

Interpolative Analog/Digital-Umsetzer sind z.B. aus IEEE Trans. Commun. Vol. Com 33, No. 3, S. 249 ff bekannt. Diese sind jedoch zur A/D-Umsetzung von Bandpaßsignalen ungeeignet, da nur die Signale, deren Spektralanteile weit unter der Abtastfrequenz liegen, mit der gewünschten Auflösung umgesetzt werden. Zur Anpassung an den Bandpaßfall wird in Electronics Letters, Band 25, Nr. 23, 9.Nov. 1989, S. 1560-1561 eine Tiefpaß-Bandpaß-Transformation vorgeschlagen, bei welchem eine Grobquantisierung in einer als Modulatorschleife mit zeitdiskretem Schleifenfilter ausgeführten ersten Stufe und die Feinquantisierung in einer nachfolgenden zweiten Stufe mittels eines-digitalen Bandpaßfilters erfolgt.

Aufgabe der vorliegenden Erfindung ist es, einen vorteilhaften A/D-Umsetzer der im Oberbegriff des Patentanspruchs 1 genannten Art anzugeben.

Die Aufgabe wird gelöst durch die kennzeichnenden Merkmale des Patentanspruchs 1. Die Unteransprüche enthalten vorteilhafte Ausgestaltungen und Weiterbildungen der Erfindung.

Die Erfindung wird im folgenden anhand der Figuren erläutert.

Nach dem Abtasttheorem für Bandpaßsignale kann ein analoges Bandpaßsignal mit der Bandbreite B durch Abtastwerte $T=1/f_A$ ohne Informationsverlust dargestellt werden, wenn zwischen der Abtastfrequenz $f_A$ und der Bandbreite B des Bandpaßsignals die Gleichung

$$f_A > 2B \quad (1)$$

und zwischen der Mittenfrequenz fm des Bandpaß-Signals und der Abtastfrequenz $f_A$ die Beziehung

$$fm = (2m + 1) \cdot f_A/4 \quad (2)$$

mit m = 0, 1, 2, ..

eingehalten wird. Im folgenden wird m als Bandpaß-Index und die Abtastung von Bandpaß-Signalen als Bandpaß-Abtastung bezeichnet.

Bei der realen Bandpaß-Abtastung mit einem Analog-Digital Umsetzer wird neben der Abtastung des Bandpaß-Signals (zeitliche Quantisierung) noch eine Amplitudenquantisierung entsprechend der Auflösung des Analog-Digital-Umsetzers durchgeführt. Der erfindungsgemäße interpolative Analog-Digital-Umsetzer setzt die Bandpaß-Signale in zwei hintereinanderge schaltete Stufen um, die beide mit der Taktfrequenz

$$f_A > 2NB \quad (3)$$

betrieben werden, wobei N viel größer als eins sein möge (hohe überabtastung), Weiterhin gilt die Gleichung (2). Somit ergibt sich für die Abtastfrequenz:

$$f_A = \frac{4}{2m + 1} fm > 2NB \quad (4)$$

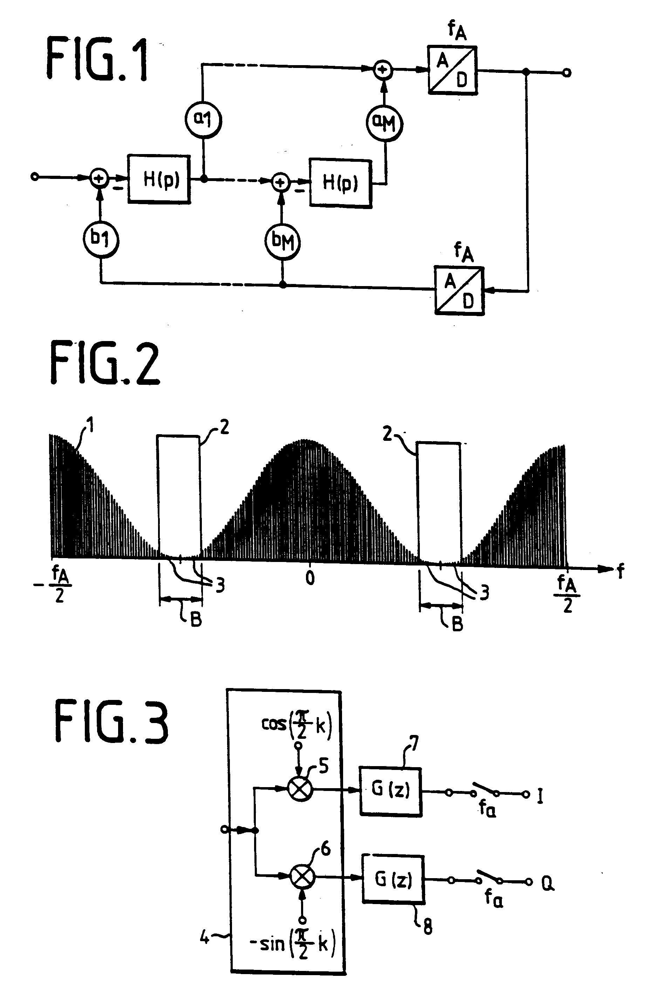

Figur 1 zeigt die erste Stufe des erfindungsgemäßen A/D-Umsetzers. Sie ist ein Regelkreis bestehend aus einem grob quantisierenden A/D-Umsetzer (im Extremfall mit nur einem Bit Auflösung), einem D/A-Umsetzer entsprechender Auflösung, Vergleichsstellen, linearen Netzwerken H(p) und Koeffizientengliedern $a_i$ und $b_i$ Die Taktrate $f_A$ für den A/D- sowie den D/A-umsetzer ist nach Gleichung (4) zu wählen.

Die Koeffizienten $a_i$ und $b_i$ sind so auszuwählen, daß der Regelkreis stabil und das Quantisierungsrauschen im Nutzfrequenzbereich minimal ist. Die Stabilitätskriterien löst man mit allgemeinen regelungstechnischen Methoden, wie z.B. dem Bode-Diagramm. Das Rauschen wird minimiert, indem man die Koeffizienten $a_i$ und $b_i$ so auswählt, daß die Schaltung näherungsweise wie ein reines System n-ter Ordnung reagiert, wobei n die Anzahl der verwendeten Netzwerke H(p) darstellt.

Die linearen Netzwerke H(p) sind Resonatoren, deren Resonanzfrequenz auf die Mittenfrequenz oder die nähere Umgebung der Mittenfrequenz abgestimmt ist. Als Resonatoren eignen sich solche Netzwerke, die gleiches oder ähnliches Verhalten besitzen wie Netzwerke, die sich durch Tiefpaß-Bandpaß-Transformation aus integrierenden oder näherungsweise integrierendenden Netzwerken 1. Ordnung ergeben. Dies sind beispielsweise:

Lineare Netzwerke, die erregt mit einer Sinusschwingung der Frequenz $f_m$, die zum Zeitpunkt t = o eingeschaltet wird, am Ausgang mit einer Sinusschwingung reagiert, deren Amplitude proportional zur Zeit t ansteigt.

oder

Lineare Netzwerke, die erregt mit einer Sinusschwingung der Frequenz $f_m$, die zum Zeitpunkt t = 0 eingeschaltet wird, am Ausgang mit einer Sinusschwingung reagiert, deren Amplitude in einem endlichen Zeitintervall $0 < t < t_o$ proportional zur Zeit t ansteigt. $t_o$ soll dabei viel kleiner als die Abtastperiode sein.

oder

Resonatoren, deren Resonanzfrequenz mit der Mittenfrequenz des Eingangssignals exakt oder näherungsweise übereinstimmt.

oder

Resonatoren, deren Resonanzfrequenz mit der Mittenfrequenz des Eingangssignals exakt oder näherungsweise übereinstimmt sowie gleiches oder ähnliches oder ähnliches Verhalten besitzen wie Netzwerke, die sich durch Tiefpaß-Bandpaß-Transformationen aus integrierenden oder näherungsweise integrierenden Netzwerken 1. Ordnung ergeben.

oder

Im Vergleich zur Bandbreite des Eingangssignals schmalbandige Bandpässe, deren Mittenfrequenz des Eingangssignals exakt oder näherungsweise übereinstimmt.

oder

Im Vergleich zur Bandbreite den Eingangssignals schmalbandige Bandpässe, deren Mittenfrequenz mit der Mittenfrequenz des Eingangssignals exakt oder näherungsweise übereinstimmt sowie gleiches oder ähnliches Verhalten besitzen wie Netzwerke, die sich durch Tiefpaß-Bandpaß-Transformation näherungsweise integrierenden Netzwerken 1. Ordnung ergeben.

Durch die Rückführung der grob quantisierten Abtastwerte und Vergleich mit dem Eingangssignal sowie den Signalverläufen am Ausgang der Netzwerke H (p) werden die Signalanteile der Fehlersignale in der Nähe der Resonanzfrequenz gegenüber anderen Signalanteilen spektral gewichtet bzw. spektral geformt. Die Ausgangssignale der Netzwerke H (p) werden entsprechend den Gewichtsfaktoren $a_i$ addiert und dem A/D zugeführt, der eine grobe Amplitudenquantisierung durchführt. Durch die Rückkopplung stellt sich am Ausgang des A/D-Umsetzers eine grob quantisierte Folge von Abtastwerten so ein, daß diese im Nutzfrequenzbereich bis auf ein Restrauschen mit dem ideal abgetasteten Eingangssignal übereinstimmt.

Fig. 2 zeigt den Verlauf des Quantisierungsrauschens 1 und des Bandpaßsignals 2, das noch einen geringen Wert Restrauschen 3 enthält. Man erkennt, daß die signifikanten Anteile des Quantisierungsrauschens im wesentlichen außerhalb des Nutzfrequenzbereichs liegen.

In der zweiten Stufe des erfindungsgemäßen A/D-Umsetzers für Bandpaß-Signale erfolgt die Feinquantisierung der zuvor grob quantisierten Abtastwerte durch digitale Interpolation. Auch diese Stufe wird mit der gleichen Taktfrequenz $f_A$ nach Gleichung (4) wie die erste Stufe betrieben. Zur Ausführung dieser Interpolation gibt es zwei grundsätzliche Möglichkeiten, nämlich entweder digitale Interpolation mit einem digitalen Bandpaß, dessen Bandmitte und Bandbreite mit dem Nutzfrequenzband des Bandpaß-Signals bei idealer Bandpaß-Abtastung ohne Amplitudenquantisierung exakt oder näherungsweise übereinstimmt oder digitale Interpolation mit einem digitalen Quadraturmodulator.

Bei der vorstehend beschriebenen digitalen Interpolation mit einem digitalen Bandpaß liegen die signifikanten Anteile des Quantisierungsrauschens außerhalb des Nutzfrequenzbereichs. Somit stehen am Ausgang dieses Bandpasses feinquantisierte Abtastwerte zur Verfügung.

Fig. 3 zeigt einen digitalen Quadraturmodulator für den erfindungsgemäßen A/D-Umsetzer für Bandpaß-Signale. Er besteht aus einem Quadraturmischer 4 mit zwei Digitalmultiplizierern 5, 6 und zwei digitalen Tiefpässen 7, 8. Die digitalen Tiefpässe 7, 8 sind so ausgelegt, daß deren Durchlaßbereiche mit dem Nutzfrequenzbereich des äquivalenten Tiefpaß-Signals exakt oder näherungsweise übereinstimmen (Grenzfrequenz $f_g$ = B/2). Da der Informationsgehalt eines Bandpaß-Signals nicht in dessen Trägerlage (Mittenfrequenz) sondern in dessen äquivalentem Tiefpaß-Signal enthalten ist, kann eine Feinquantisierung des äquivalenten Tiefpaß-Signals durchgeführt werden. Das Ausgangssignal der ersten Stufe wird im digitalen Quadraturmischer 4 mit dem Digitalmultiplizierer 5 mit Cos ( $\pi/2 \times$ K) multipliziert und durch den digitalen Tiefpaß 7 geschickt, an dessen Ausgang der feinquanti sierte Realteil des äquivalenten Tiefpaß-Signals zur Verfügung steht. Ebenso wird das Ausgangssignal der ersten Stufe im digitalen Quadraturmischer 4 mit dem Digitalmultiplizierer mit -sin ( $\pi/2 \times$ K) multipliziert und dann durch den digitalen Tiefpaß 8 geschickt, an dessen Ausgang der feinquantisierte Imaginärteil des äquivalenten Tiefpaß-Signals zur Verfügung steht.

Die Abtastrate am Ausgang der beiden Tiefpässe 5, 6 kann entsprechend der Bandbreite der digitalen Interpolationsfilter um den Faktor 2 N reduziert werden.

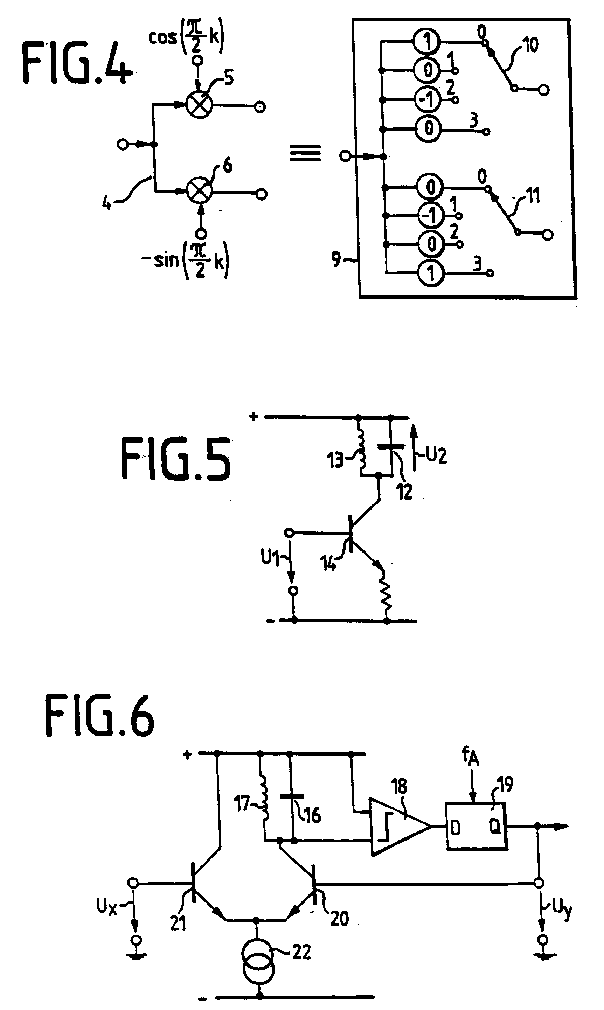

Fig. 4 zeigt den digitalen Quadraturmischer 4 und dem gegenübergestellt einen vereinfachten digitalen Quadraturmischer 9. Da die beiden digitalen Trägerfolgen Cos (k $\times$ $\pi/2$) und sin (k $\times$ $\pi/2$) nur Werte aus der Menge { -1,0,1} annehmen, kann bei der Realisierung des digitalen Quadraturmischers 4 auf die Digitalmultiplizierer 5 und 6 verzichtet werden. Stattdessen benutzt man Schalter 10, 11 die synchron mit der Abtastfrequenz $f_A$ die Schaltstellungen 0, 1, 2, 3 periodisch durchlaufen und digitale Elemente, die die Trivialmultiplikation mit den Faktoren 0, 1 und -1 durchführen.

Fig. 5 zeigt eine schaltungstechnische Realisierung eines Netzwerkes H (p). Es besteht aus einem Parallelschwingkreis mit dem Kondensator 12 und Spule 13, der von dem Transistor 14 in Emitterschaltung als spannungsgesteuerte Stromquelle gespeist wird. Die ohmschen Widerstände zur Arbeitspunkteinstellung sind nicht dargestellt.

Fig. 6 zeigt eine schaltungstechnische Realisierung der ersten Stufe mit nur einem linearen Netzwerk H (p). Sie besteht aus -dem Parallelschwingkreis mit Kondensator 16 und Spule 17, dem Komparator 18, dem Flip-flop 19, den Transistoren 20, 21 und einer spannungsgesteuerten Stromquelle 22. Das Flip-Flop 19 wird mit der Frequenz $f_A$ betrieben und übernimmt so die Schaltzustände des Komparators 18. Dieser wiederum wird vom Parallelschwingkreis mit Kondensator 16 und Spule 17 angesteuert Die Kollektorströme der beiden Transistoren werden von der Differenz der Spannungen $U_x$ und $U_y$ gesteuert. Damit wirkt der Differenzverstärker bestehend aus den Transistoren 20, 21 und der Konstantstromquelle 22 gleichzeitig als Vergleichsstelle und als spannungsgesteuerte Stromquelle zur Speisung des Parallelschwingkreises bestehend aus Kondensator 16 und Spule 17 und der Konstantstromquelle 22. Die Konstantstromquelle 22 kann z.B. durch einen ohmschen Widerstand oder eine Transistorschaltung realisiert sein.

## Patentansprüche

1. Interpolativer Analog/Digital-Umsetzer mit einer ersten Stufe, welche ein analoges Eingangssignal durch Überabtastung mit einer Abtastfrequenz $f_A$ in der Amplitude grob quantisiert, und das durch die grobe Amplitudenquantisierung erzeugte Quantisierungsrauschen so formt, daß die signifikanten Rauschanteile außerhalb des Nutzfrequenzbereichs liegen, und mit einer zweiten Stufe, welche das in der ersten Stufe grob quantisierte Signal interpoliert, dadurch gekennzeichnet, daß das Eingangssignal ein Bandpaßsignal der Bandbreite B und der Mittenfrequenz fm ist, daß die Abtastrate

$$f_A = \frac{4}{2m + 1} \, fm > 2NB$$

beträgt mit m = 0,1,2,... und gemäß $f_A > 2$ NB mit N >> 1 wesentlich größer ist als die Bandbreite des Eingangssignals, und daß das grob quantisierte Signal in der zweiten Stufe zunächst digital quadraturgemischt und mittels zweier digitalen Tiefpässe digital interpoliert wird, an deren Ausgänge Abtastwerte von Inphasen- und Qudraturkomponente des Eingangssignals zur Verfügung stehen.

2. Umsetzer nach Anspruch 1, dadurch gekennzeichnet, daß der Durchlaßbereich der digitalen Tiefpässe exakt oder näherungsweise mit dem dem Bandpaßsignal äquivalenten Tiefpaßsignal übereinstimmt.

3. Umsetzer nach Anspruch 1 oder 2, dadurch gekennzeichnet, daß der Quadraturmischer aus zwei vorzugsweise elektronischen Schaltern besteht, die die Schalterstellen 0, 1, 2, 3 periodisch durchlaufen und den jeweiligen Schalterstellen digitaler Elemente zugeordnet sind, die die Multiplikation mit 0; 1 und -1 durchführen.

4. Umsetzer nach Anspruch 1 bis 3, dadurch gekennzeichnet, daß die Struktur der ersten Stufe aus einem A/D-Umsetzer mit entsprechender Auflösung, aus mindestens einem Netzwerk H (p), aus Koeffizientengliedern $a_i$ und $b_i$, die auch die Werte 0 und 1 annehmen können, sowie aus Vergleichsstellen besteht.

5. Umsetzer nach Anspruch 4, dadurch gekennzeichnet, daß die Koeffizienten $a_i$ und $b_i$ so ausgewählt werden, daß die Schaltung der ersten Stufe stabil ist und daß Quantisierungsrauschen optimal geformt wird.

6. Umsetzer nach Anspruch 4 oder 5, dadurch gekennzeichnet, daß das Netzwerk H (p) oder die Netzwerke H (p) aus Resonatoren bestehen, deren Resonanzfrequenzen mit der Mittenfrequenz $f_m$ des Eingangssignals exakt oder näherungsweise übereinstimmen.

**Claims**

1. An interpolative analog/digital converter including a first stage which coarsely quantizes the amplitude of an analog input signal by oversampling with a sampling frequency $f_A$ and shapes the quantization noise produced by the coarse amplitude quantization in such a manner that the significant noise components lie outside of the useful frequency range, the converter further including a second stage which interpolates the signal that was coarsely quantized in the first stage, **characterized in that** the input signal is a bandpass filter signal of the bandwidth B with a center frequency fm, the sampling rate being

$$f_A = \frac{4}{2m + 1} fm > 2NB$$

where m = 0, 1, 2, ..., and, according to $f_A > 2$ NB, where N >> 1, is significantly greater than the bandwidth of the input signal; and the coarsely quantized signal is initially digitally quadrature mixed in the second stage and digitally interpolated by means of two digital lowpass filters at whose outputs sampling values are available of the in-phase and quadrature components of the input signal.

2. A converter according to claim 1, characterized in that the passband range of the digital lowpass filters exactly or approximately coincides with the lowpass filter signal that is equivalent to the bandpass filter signal.

3. A converter according to claim 1 or 2, characterized in that the quadrature mixer is composed of two preferably electronic switches which periodically pass through the switch positions 0, 1, 2 and 3 and are associated with the respective switch positions of digital elements that perform a multiplication by 0, 1 and -1.

4. A converter according to claims 1 to 3, characterized in that the structure of the first stage is composed of an A/D converter of the corresponding resolution, at least one network H(p), coefficient members $a_i$ and $b_i$, which may also take on the values 0 and 1, and of reference junctions.

5. A converter according to claim 4, characterized in that the coefficients $a_i$ and $b_i$ are selected in such a manner that the circuit of the first stage is stable and the quantization noise is shaped in an optimum manner.

6. A converter according to claim 4 or 5, characterized in that the network H(p) or the networks H(p) are composed of resonators whose resonant frequencies exactly or approximately coincide with the center frequency $f_m$ of the input signal.

**Revendications**

1. Convertisseur analogique-numérique à interpolation, comportant un premier étage, qui traite un signal d'entrée analogique pour le quantifier grossièrement en amplitude en l'analysant au moyen d'une fréquence d'exploration $f_A$, et qui met en forme les bruits de quantification résultant de cette quantification grossière, de telle manière que les parties significatives se trouvent en dehors de la zone des fréquences utiles, et comportant un deuxième étage pour interpoler le signal grossièrement quantifié dans le premier étage, caractérisé en ce que le signal d'entrée est un signal passe-bande ayant une largeur de bande B et une fréquence moyenne $f_m$, en ce que la cadence d'exploration $f_A$ satisfait la relation :

$$f_A = \frac{4}{2m + 1} f_m > 2 N B$$

Dans laquelle m = 0,1,2,... , et, puisque $f_A > 2$ N B avec N >> 1, la cadence d'exploration $f_A$ étant étant supérieure à la largeur de bande du signal d'entrée, et en ce que le signal grossièrement quantifié subit d'abord un mélange en quadrature numérique dans le deuxième étage, plus une interpolation numérique au moyen de deux passe-bas numériques,dont les sorties permettent d'avoir des valeurs d'analyse des composantes en phase et en quadrature du signal d'entrée.

2. Convertisseur selon la revendication 1, caractérisé en ce que la bande passante des passe-bas numériques correspond exactement ou approximativement au signal passe-bas équivalent au signal de la bande passante.

3. Convertisseur selon la revendication 1 ou 2, caractérisé en ce que le mélangeur de quadrature est constitué par deux commutateurs de préférence électroniques, ces commutateurs passant périodiquement par des positions de commutation 0,1, 2,3, des éléments numériques étant associés à chaque commutateur pour effectuer la multiplication par 0 ; 1 et -1.

4. Convertisseur selon les revendications 1 à 3, caractérisé en ce que la structure de son premier étage comporte un convertisseur analogique-numérique de résolution correspondante, au moins un réseau H (p) constitué d'éléments à coefficients $a_i$ et $b_i$ pouvant aussi prendre les valeurs 0 et 1, et des postes comparateurs.

5. Convertisseur selon la revendication 4, caractérisé en ce que les coefficients $a_i$ et $b_i$ sont choisis pour que le fonctionnement du premier étage soit stable, et pour que le bruit de quantification soit formé d'une manière optimum.

6. Convertisseur selon la revendication 4 ou 5, caractérisé en ce que le réseau H (p) ou les réseaux H(p) sont constitués par des résonateurs dont les fréquences de résonance coïncident exactement ou approximativement avec la fréquence moyenne $f_m$ du signal d'entrée.

# FIG.1

# FIG.2

# FIG.3

FIG.4

$\cos\left(\frac{\pi}{2}k\right)$

$-\sin\left(\frac{\pi}{2}k\right)$

FIG.5

FIG.6